# EUROPEAN PATENT APPLICATION

(11) **EP 2 629 335 A1**
(43) Date of publication of application: **21.08.2013**
(21) Application number: 12799855.7
(22) Date of filing: 02.02.2012
(51) Int. Cl.: H01L 31/04

(54) **THIN FILM SOLAR CELL AND METHOD FOR MANUFACTURING SAME**

(30) Priority: 17.06.2011 JP 2011134985
(71) Applicant: Fuji Electric Co., Ltd., Kawasaki-shi Kanagawa 210-9530 (JP)
(72) Inventor: NAKAHARA Hiroaki, Kawasaki-shi Kanagawa 210-9530 (JP); TAKEUCHI Masaki, Kawasaki-shi Kanagawa 210-9530 (JP); WADA Takehito, Kawasaki-shi Kanagawa 210-9530 (JP); SAWAYANAGI Satoshi, Kawasaki-shi Kanagawa 210-9530 (JP)
(74) Representative: MERH-IP Matias Erny Reichl Hoffmann
(86) International application number: PCT/JP2012/052400
(87) International publication number: WO 2012/172827

(57) **Abstract**

This invention provides a thin film photovoltaic cell in which the effective area of a transparent electrode layer is expanded and the output of the thin film photovoltaic cell is increased, and moreover the insulating properties at the second penetrating hole are secured so that the defect rate during manufacture of the thin film photovoltaic cell can be lowered; and also provides a method of manufacture of the thin film photovoltaic cell.

The thin film photovoltaic cell is configured such that a rear face electrode layer, a photoelectric conversion layer and a transparent electrode layer are stacked in this order on one face of an insulating substrate, a back face electrode layer is deposited on the other face, and both electrode layers are electrically connected via a second penetrating hole which penetrates the insulating substrate; and is further configured such that a protective layer is provided at least in a region which surrounds the second penetrating hole and which is located between the transparent electrode layer and the photoelectric conversion layer stacked on the rear face electrode layer, or between the rear face electrode layer and the photoelectric conversion layer, and by using a laser to remove a transparent electrode on the periphery of the second penetrating hole in the region in which the protective layer is formed, the two electrode layers are electrically insulated.

## Description

### TECHNICAL FIELD

This invention relates to a photovoltaic cell in a metal electrode layer, a photoelectric conversion layer and a transparent electrode layer are stacked on a film substrate.

### BACKGROUND ART

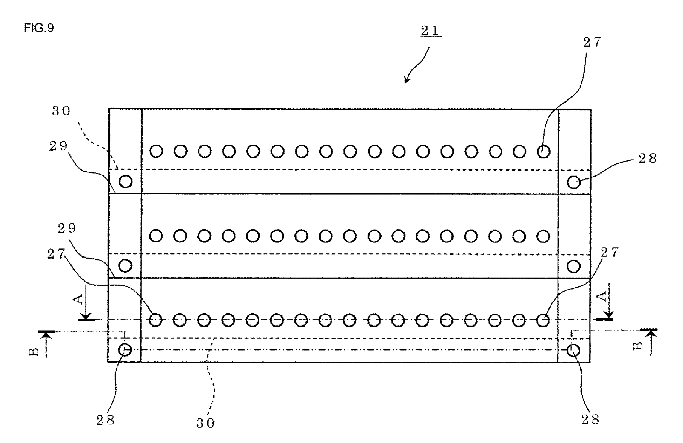

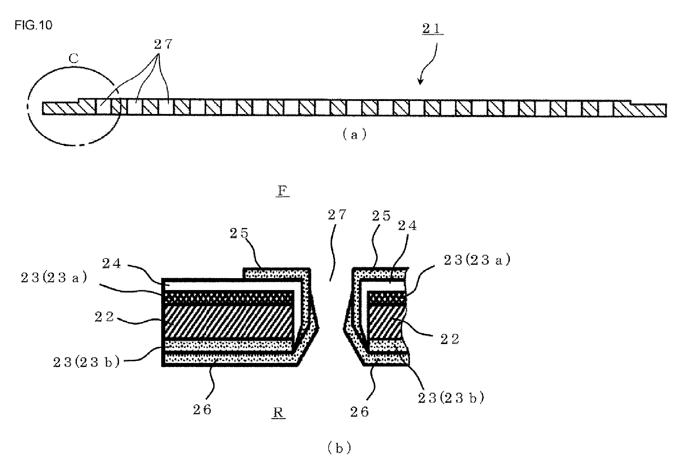

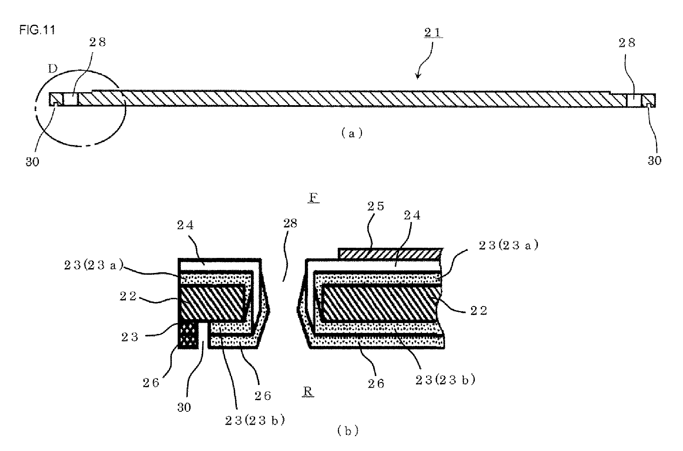

FIG. 9 is a plane view of a thin film photovoltaic cell of the prior art. FIG. 10 shows cross-sectional views along line A-A in FIG. 9; FIG. 10B is an enlarged view of the portion C in FIG. 10A. FIG. 11 shows cross-sectional views along line B-B in FIG. 9; FIG. 11B is an enlarged view of the portion D in FIG. 11A.

As shown in FIG. 10 and FIG. 11, the thin film photovoltaic cell 21 of the prior art comprises an insulating substrate 22. If the side of the light-receiving face of the thin film photovoltaic cell 21 is F, and the side opposite the light-receiving face is R, then a metal electrode layer 23 is formed on both the light-receiving face side F and the side opposite the light-receiving side R of the insulating substrate 22. Here, the metal electrode layer 23 on the one face on the light-receiving face side F of the insulating substrate 22 functions as a rear face electrode layer 23a, and the metal electrode layer 23 on the other face which is on the side opposite the light-receiving face R of the insulating substrate 22 functions as a first back face electrode layer 23b.

Further, as shown in FIG. 10 and FIG. 11, a photoelectric conversion layer 24 and a transparent electrode layer 25 are stacked in this order on the rear face electrode layer 23a. On the first back face electrode layer 23b is stacked a second back face electrode layer 26.

As shown in FIG. 10, first penetrating holes 27 which penetrate the insulating substrate 22 are provided in the insulating substrate 22, and the transparent electrode layer 25 and second back face electrode layer 26 are electrically connected via the first penetrating holes 27. As shown in FIG. 11, second penetrating holes 28 which penetrate the insulating substrate 22 are provided in the insulating substrate 22, and the rear face electrode layer 23a and first back face electrode layer 23b are electrically connected via the second penetrating holes 28.

As shown in FIG. 9, all of the layers stacked on the one face on the light-receiving face side F of the insulating substrate 22 (the rear face electrode layer 23a, photoelectric conversion layer 24, and transparent electrode layer 25) are divided by first patterning lines 29, and all of the layers stacked on the other face on the side opposite the light-receiving face R of the insulating substrate 22 (the first back face electrode layer 23b and second back face electrode layer 26) are divided by second patterning lines 30. By this means, the layers stacked on the insulating substrate 22 are divided into a plurality of unit cells.

Here, the first patterning lines 29 and second patterning lines 30 are disposed alternately in the insulating substrate 22. The isolation positions of the electrode layers on the two faces, on the light-receiving face side F and on the side opposite the light-receiving face R of the insulating substrate 22, are mutually shifted, and moreover by connecting the electrode layers on the two faces of the insulating substrate 22 using the second penetrating holes 28, a structure is obtained in which adjacent unit cells are connected in series.

Patent Document 1 discloses another example of a thin film photovoltaic cell of the prior art. In the thin film photovoltaic cell of Patent Document 1, a first electrode layer, photoelectric conversion layer, and second electrode layer are stacked on one face of a film substrate comprising an electrically insulating resin, and on the opposite side (rear face) of the film substrate are stacked a third electrode layer and a fourth electrode layer.

Patent Document 2 discloses still another example of a thin film photovoltaic cell of the prior art. In the thin film photovoltaic cell of Patent Document 2, connecting holes are plugged by printed electrodes comprising a conductive material (see in particular paragraph [0035] and FIG. 27).

Patent Document 1: Japanese Patent Application Laid-open No. 2001-298203
Patent Document 2: Japanese Patent Application Laid-open No. H6-342924

However, the above-described configuration of FIG. 9 to FIG. 11 has the following problems.

In the configuration of the prior art, when forming the transparent electrode layer 25 such that the transparent electrode layer 25 and the second back face electrode layer 26 are not in contact at the second penetrating holes 28, mask treatment is performed in the vicinity of the second penetrating holes 28. Hence as shown in FIG. 11B, the transparent electrode layer 25 is not formed in the vicinity of the second penetrating holes 28, and thus in the configuration of the prior art, the effective area of the transparent electrode layer 25 has been limited. The second penetrating holes 28 are disposed at a constant interval, taking into account the electrical resistance of the first back face electrode layer 23b and the second back face electrode layer 26, and regions in which the transparent electrode layer 25 is not formed are therefore provided at a constant interval on the insulating substrate 22. Hence the effective area of the transparent electrode layer 25 is decreased, and there is the problem that the output of the thin film photovoltaic cell 21 is reduced proportionally thereto.

Further, mask treatment is performed in the vicinity of the second penetrating holes 28, and thus due to contact between the transparent electrode layer 25 and similar on the insulating substrate 22 with the mask, there has been the possibility of damage to the transparent electrode layer 25 and similar on the insulating substrate 22. When there is damage to a layer on the insulating substrate 22, leakage currents and similar are increased, and thus there has been the problem of an increase in the defect rate when manufacturing thin film photovoltaic cells 21.

Further, in the case of the technique disclosed in Patent Document 2, connecting holes are plugged by a conductive material, and thus the insulating properties at the connecting holes are inadequate, and there is the problem that leakage currents are increased.

### DISCLOSURE OF THE INVENTION

This invention was devised in the light of such circumstances, and an object thereof is to provide a thin film photovoltaic cell and a method of manufacture thereof, in which the effective area of the transparent electrode layer is expanded and the output of the thin film photovoltaic cell is increased, and moreover the insulating properties at the second penetrating holes are secured, so that the defect rate during manufacture of the thin film photovoltaic cell can be lowered.

In order to resolve the abovementioned problems of the prior art, this invention provides a thin film photovoltaic cell comprising a rear face electrode layer, a protective layer, a photoelectric conversion layer, and a transparent electrode layer stacked in this order on one face of an insulating substrate, and a back face electrode layer deposited on the other face of the insulating substrate, the insulating substrate being divided into a plurality of unit cells by alternately forming patterning lines in the layers stacked on the two faces of the insulating substrate, the transparent electrode layer and the back face electrode layer being electrically connected via a first penetrating hole which penetrates the insulating substrate, the rear face electrode layer and the back face electrode layer being electrically connected via a second penetrating hole which penetrates the insulating substrate, and adjacent unit cells being connected in series, wherein a protective layer is provided at least in a region which surrounds the periphery of the second penetrating hole and which is located between the photoelectric conversion layer and the transparent electrode layer, or between the rear face electrode layer and the photoelectric conversion layer, and by using a laser to remove a transparent electrode on the periphery of the second penetrating hole in the region in which the protective layer is formed, the transparent electrode layer and the back face electrode layer are electrically insulated.

Further, the back face electrode layer may be configured such that a first back face electrode layer and a second back face electrode layer are stacked in this order on the other face of the insulating substrate; in this case, a structure is employed in which the transparent electrode layer and the second back face electrode layer are electrically connected via a first penetrating hole which penetrates the insulating substrate, the rear face electrode layer and first back face electrode layer are electrically connected via a second penetrating hole which penetrates the insulating substrate, and by removing the transparent electrode on the periphery of the second penetrating hole using a laser, the transparent electrode layer and the second back face electrode layer are electrically insulated.

In a thin film photovoltaic cell of this invention, the insulating substrate is formed from a film material, and the film material is a heat-resistant film of a polyimide, a polyamideimide, or polyethylene naphthalate.

In a thin film photovoltaic cell of this invention, the photoelectric conversion layer is any one of an amorphous semiconductor, an amorphous semiconductor including microcrystals, a dye-sensitized photovoltaic cell, and an organic photovoltaic cell.

In order to resolve the abovementioned problems of the prior art, a method of manufacture of a photovoltaic cell of this invention includes a step of forming a second penetrating hole in an insulating substrate; a step of forming a rear face electrode layer on one face of the insulating substrate, and of forming a first back face electrode layer on the other face of the insulating substrate; a step of forming a first penetrating hole in the insulating substrate after forming the rear face electrode layer and the first back face electrode layer; a step of stacking a photoelectric conversion layer on the rear face electrode layer; a step of stacking a protective layer on the photoelectric conversion layer at least in a region surrounding the periphery of the second penetrating hole; a step of stacking a transparent electrode layer on the photoelectric conversion layer having a portion on which the protective layer has been stacked, and of stacking a second back face electrode layer on the other face of the insulating substrate; a step of alternately forming patterning lines in the layers stacked on the two faces of the insulating substrate, and of dividing the insulating substrate into a plurality of unit cells; and a step of isolating the transparent electrode in a shape which surrounds the second penetrating hole. Here, the order of the step of forming patterning lines and the step of performing isolation may be reversed.

The protective layer may be provided between the photoelectric conversion layer and the transparent electrode layer, or may be provided between the rear face electrode layer and the photoelectric conversion layer. That is, a method of manufacture may include a step of forming a second penetrating hole in an insulating substrate; a step of forming a rear face electrode layer on one face of the insulating substrate, and of forming a first back face electrode layer on the other face of the insulating substrate; a step of forming a first penetrating hole in the insulating substrate after forming the rear face electrode layer and the first back face electrode layer; a step of stacking a protective layer on the rear face electrode layer at least in a region surrounding the periphery of the second penetrating hole; a step of stacking a photoelectric conversion layer on the rear face electrode layer having a portion on which the protective layer has been stacked; a step of stacking a transparent electrode layer on the photoelectric conversion layer, and of stacking a second back face electrode layer on the other face of the insulating substrate; a step of alternately forming patterning lines in the layers stacked on the two faces of the insulating substrate, and of dividing the insulating substrate into a plurality of unit cells; and a step of dividing the transparent electrode layer on the periphery of the second penetrating hole.

Further, the protective layer is formed from a polyimide or other resin material having an optical absorptivity at wavelength 532 nm of 20% or higher.

Further, isolation fabrication may be performed on the transparent electrode so as to surround the second penetrating hole, using a laser at wavelength 193 nm to 532 nm.

In a thin film photovoltaic cell of this invention, a rear face electrode layer, photoelectric conversion layer and transparent electrode layer are stacked in this order on one face of an insulating substrate, a back face electrode layer is deposited on the other face of the insulating substrate, and by alternately forming patterning lines in the layers stacked on the two faces of the insulating substrate, the insulating substrate is divided into a plurality of unit cells; the transparent electrode layer and the second back face electrode layer are electrically connected via a first penetrating hole which penetrates the insulating substrate, the rear face electrode layer and the back face electrode layer are electrically connected via a second penetrating hole which penetrates the insulating substrate, and adjacent unit cells are connected in series. A protective layer is provided at least in a region which surrounds the periphery of the second penetrating hole and which is located between the photoelectric conversion layer and the transparent electrode layer, or between the rear face electrode layer and the photoelectric conversion layer, so that the transparent electrode can be isolated by a laser on the periphery of the second penetrating hole, the effective area of the transparent electrode layer can be expanded, and the output of the thin film photovoltaic cell can be increased.

Further, in a thin film photovoltaic cell of this invention, the insulating substrate is formed from a film material, and thus a method of transporting the insulating substrate using rolls for transporting (for example, the roll-to-roll method) can be used in manufacturing, so that thin film photovoltaic cell manufacturing can be performed efficiently.

Further, a method of manufacture of thin film photovoltaic cells of this invention includes a step of forming a second penetrating hole in an insulating substrate; a step of forming a rear face electrode layer on one face of the insulating substrate, and forming a first back face electrode layer on the other face of the insulating substrate; a step of forming a first penetrating hole in the insulating substrate after forming the rear face electrode layer and first back face electrode layer; a step of stacking a photoelectric conversion layer on the rear face electrode layer; a step of stacking a protective layer on the photoelectric conversion layer, at least in regions surrounding the periphery of the second penetrating hole; a step of stacking a transparent electrode layer on the photoelectric conversion layer having a portion on which the protective layer has been stacked, and stacking a second back face electrode layer on the side of the other face of the insulating substrate; a step of alternately forming patterning lines in the layers stacked on the two faces of the insulating substrate, and dividing the insulating substrate into a plurality of unit cells; a step, either including a process of insulating the transparent electrode and the rear face electrode by isolating the transparent electrode so as to surround the second penetrating hole, or, after forming the first penetrating hole, of stacking a protective layer on the rear face electrode layer at least in regions surrounding the periphery of the second penetrating hole; a step of stacking a photoelectric conversion layer on the rear face electrode layer having a portion on which the protective layer has been stacked; a step of stacking a transparent electrode layer on the photoelectric conversion layer and of stacking a second back face electrode layer on the side of the other face of the insulating substrate; a step of alternately forming patterning lines in the layers stacked on the two faces of the insulating substrate, and dividing the insulating substrate into a plurality of unit cells; and a step of dividing the transparent electrode layer on the periphery of the second penetrating hole. Thus there is no longer a need to perform mask treatment in the vicinity of the second penetrating hole as in the prior art, and the production yield during manufacture of thin film photovoltaic cells is improved. In addition, there is no longer a need to perform mask treatment in the vicinity of the second penetrating hole, so that there is no longer damage to layers on the substrate due to contact of the mask with layers on the substrate. Consequently there is no longer an increase in leakage currents in the thin film photovoltaic cell, and the defect rate when manufacturing thin film photovoltaic cells can be lowered.

Moreover, the transparent electrode is isolated at least on the periphery of the second penetrating hole, and in the power generation region the transparent electrode layer and the back face electrode layer are isolated, so that insulation in the second penetrating hole can be secured.

### BRIEF DESCRIPTION OF THE DRAWINGS

FIG. 1 is a plane view of the thin film photovoltaic cell of an embodiment of the invention;
FIG. 2 shows cross-sectional views of FIG. 1 of the invention, in which FIG. 2A is the cross-section at line E-E and FIG. 2B is an enlarged view of H in FIG. 2A;
FIG. 3 shows cross-sectional views of FIG. 1 of the invention, in which FIG. 3A is the cross-section at line G-G and FIG. 3B is an enlarged view of J in FIG. 3A (first embodiment);
FIG. 4 is an enlarged plane view of the second penetrating holes in the first embodiment of the invention;
FIG. 5 is a flowchart when manufacturing thin film photovoltaic cells of first and second embodiments of the invention;
FIG. 6 shows cross-sectional views of FIG. 1 of the second embodiment of the invention, in which FIG. 6A is the cross-section at line G-G and FIG. 6B is an enlarged view of K in FIG. 6A;
FIG. 7 is a flowchart when manufacturing thin film photovoltaic cells of the second embodiment of the invention;
FIG. 8 shows the transmittance versus wavelength of a transparent electrode layer;
FIG. 9 is a plane view of a thin film photovoltaic cell of the prior art;
FIG. 10A is a cross-sectional view at line A-A in FIG. 9 and FIG. 10B is an enlarged view of C in FIG. 10A; and
FIG. 11A is a cross-sectional view at line B-B in FIG. 9 and FIG. 11B is an enlarged view of D in FIG. 11A.

### BEST MODE FOR CARRYING OUT THE INVENTION

Below, embodiments of the invention are explained using the drawings. In all the drawings, the same constituent elements are assigned the same symbols, and explanations are omitted as appropriate.

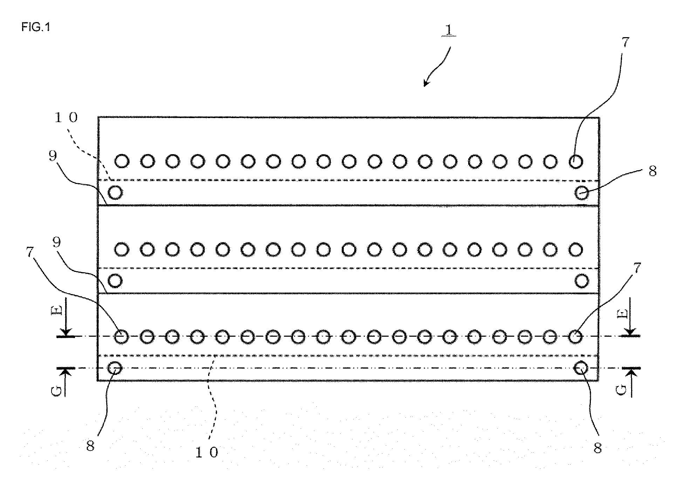

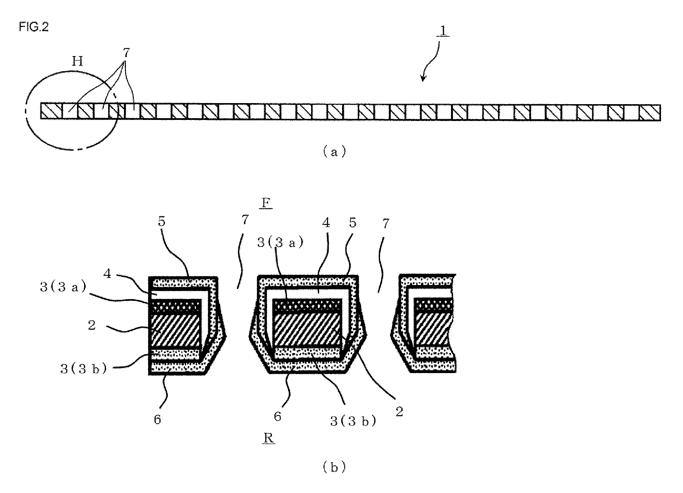

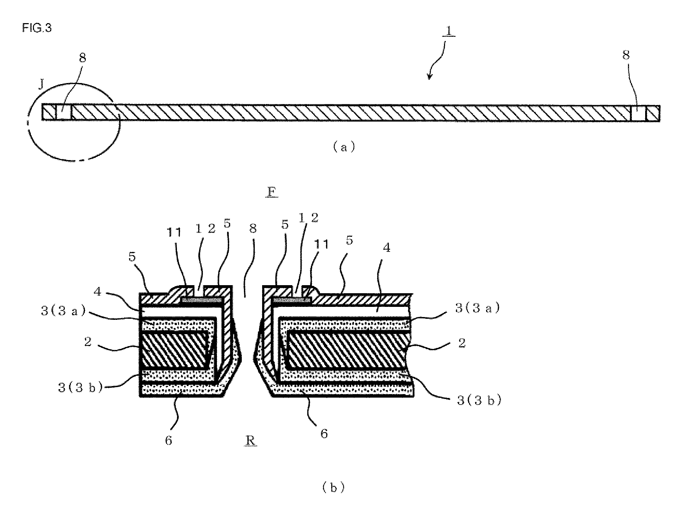

FIG. 1 is a plane view of the thin film photovoltaic cell of an embodiment. FIG. 2A is a cross-sectional view along line E-E in FIG. 1, and FIG. 2B is an enlarged view of H in FIG. 2A. FIG. 3A is a cross-sectional view at line G-G in FIG. 1, and FIG. 3B is an enlarged view of J in FIG. 3A.

As shown in FIG. 1, in the thin film photovoltaic cell 1 of the embodiment of the invention, a plurality of first penetrating holes 7 and a plurality of second penetrating holes 8 are provided, and the surface side (light-receiving face side) of the thin film photovoltaic cell 1 is divided by first patterning lines 9 to form a plurality of unit photovoltaic cells. The first patterning lines 9 are configured so as to be delimited by the collection of the first penetrating holes 7 and second penetrating holes 8. The surface side (non-light receiving face side) of the thin film photovoltaic cell 1 is divided by second patterning lines 10 provided at positions which isolate the first penetrating holes 7 and second penetrating holes 8 delimited by the first patterning lines 9.

A difference in plane views between the thin film photovoltaic cell 1 of the embodiment of the invention shown in FIG. 1 and the thin film photovoltaic cell 21 of the prior art shown in FIG. 10 is that in FIG. 10 there exist regions on both sides of the thin film photovoltaic cell 21 in which the transparent electrode layer 25 is not deposited, but in FIG. 1, there are no such locations, and the transparent electrode layer (5) exists over the entire faces.

Next, the cross-sectional structure of the thin film photovoltaic cell 1 of the embodiment of the invention is explained, referring to FIG. 2 and FIG. 3.

The thin film photovoltaic cell 1 of this embodiment comprises an insulating substrate 2. This insulating substrate 2 is formed from a film material, and is for example formed from a polyimide, polyamideimide, or polyethylene naphthalate, or from an aramid or other material.

As shown in FIG. 2, a metal electrode layer 3 comprising Ag or another metal is formed on both faces of the insulating substrate 2. Here, the metal electrode layer 3 on the face on the light-receiving side, which is the side F, of the insulating substrate 2 functions as a rear face electrode layer 3a, and the metal electrode layer 3 on the face on the side opposite the light-receiving side, which is the side R, of the insulating substrate 2 functions as a first back face electrode layer 3b.

On the rear face electrode layer 3a, a photoelectric conversion layer 4 and a transparent electrode layer 5 are stacked in this order, and on the first back face electrode layer 3b on the other face of the insulating substrate 2, a second back face electrode layer 6 is stacked. On the inner faces of the first penetrating holes 7 in FIG. 2B, the transparent electrode layer 5 and the second back face electrode layer 6 are electrically connected.

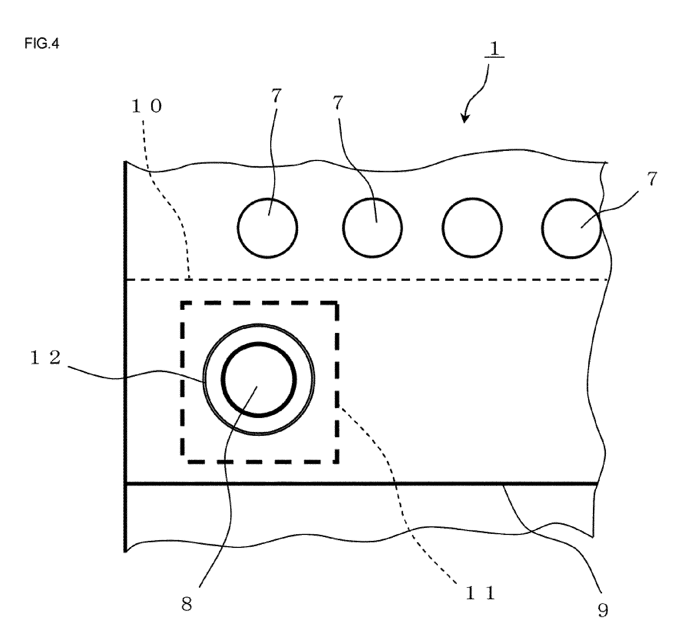

Next, as shown in FIG. 3, within the second penetrating holes 8, the photoelectric conversion layer 4, protective layer (insulating layer) 11 and transparent electrode layer 5 are stacked in this order on the rear face electrode layer 3a on the light-receiving face side which is the side F of the insulating substrate 2. The protective layer 11 has holes equivalent to the second penetrating holes 8, having a prescribed width and disposed on the periphery of the second penetrating holes 8 in the transparent electrode layer 5. The protective layer 11 may have holes circular in shape, near the center and equivalent to the second penetrating holes 8, or the holes may be rectangular. FIG. 4 is an enlarged plane view of the vicinity of a second penetrating hole 8 in the embodiment of the invention. In FIG. 4, the protective layer 11, rectangular in shape and having a hole equivalent to the second penetrating hole 8 in the center, is disposed below the transparent electrode layer 5 on the surface so as to surround the periphery of the second penetrating hole 8. Further, a third patterning line (isolation groove) 12 is provided on the outer periphery of the second penetrating hole 8 and within the range over which the protective layer 11 is disposed.

The third patterning line 12 is configured by using laser fabrication and similar to remove the transparent electrode layer 5 as shown in FIG. 3B; the protective layer 11 prevents exposure and isolation fabrication of the photoelectric conversion layer 4 and rear face electrode layer 3a positioned therebelow. The cross-sectional structure shown in FIG. 3B is a characteristic of the first embodiment of the invention.

Here, as the photoelectric conversion layer 4, an amorphous semiconductor, amorphous compound semiconductor, dye-sensitized photovoltaic cell, or organic photovoltaic cell can be used.

Further, as shown in FIG. 1, the layers (rear face electrode layer 3a, photoelectric conversion layer 4 and transparent electrode layer 5) stacked on the face on the light-receiving side, which is the side F, of the insulating substrate 2 are divided into a plurality by first patterning lines 9 formed by laser fabrication.

The layers (first back face electrode layer 3b and second back face electrode layer 6) stacked on the face on the non-light receiving side, which is the side R, of the insulating substrate 2 are similarly divided into a plurality by second patterning lines 10 formed by laser fabrication. Here, the first patterning lines 9 and second patterning lines 10 are disposed alternately in the insulating substrate 2.

As shown in FIG. 1 and FIG. 2, first penetrating holes 7 which penetrate the insulating substrate 2 are provided in the insulating substrate 2. The transparent electrode layer 5 and second back face electrode layer 6 are connected so as to mutually overlap on the side wall portions of the first penetrating holes 7. By this means, unit cells (unit photovoltaic cells) are formed comprising the layers on the face on the light-receiving side, which is the side F, and the layers on the face on the non-light receiving side, which is the side R, of the insulating substrate 2.

Further, as shown in FIG. 1 and FIG. 3, second penetrating holes 8 which penetrate the insulating substrate 2 are provided in the insulating substrate 2. The rear face electrode layer 3a and first back face electrode layer 3b are electrically connected via the side wall portions of the second penetrating holes 8. That is, adjacent unit cells are electrically connected by the second penetrating holes 8. Specifically, the first and second penetrating holes 7 and 8 are used to make connections in the order of the first and second back face electrode layers 3b, 6 → first penetrating holes 7 → transparent electrode layer 5 → photoelectric conversion layer 4 → rear face electrode layer 3a → second penetrating holes 8 → first back face electrode layer 3b.

As explained above, by electrically connecting adjacent unit cells in series, the thin film photovoltaic cell 1 is configured.

As a characteristic of this embodiment, the power generation portion of the transparent electrode layer 5 is isolated by the third patterning lines 12 on the peripheries of the second penetrating holes 8, as shown in FIG. 3.

In the above-described configuration, the transparent electrode layer 5 and second back face electrode layer 6 are electrically insulated by the third patterning lines 12 provided in the transparent electrode layer 5 on the peripheries of the second penetrating holes 8.

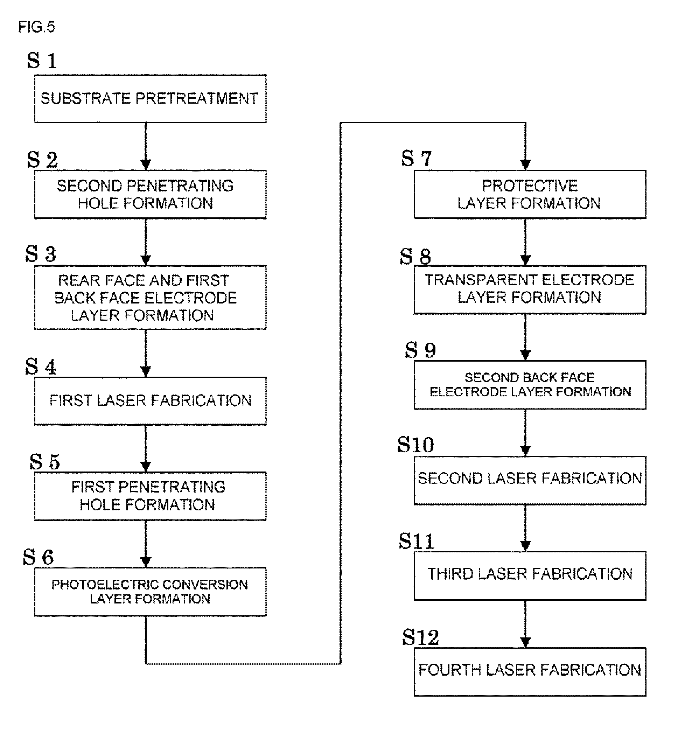

Next, a method of manufacture of the thin film photovoltaic cell of this embodiment of the invention is explained referring to the drawings. FIG. 5 is a flowchart for manufacture of the thin film photovoltaic cell 1 of this embodiment.

The thin film photovoltaic cell 1 of this embodiment uses, as the insulating substrate 2, a film material such as that described above. As the method of manufacture of the thin film photovoltaic cell 1, a roll-to-roll method and an inkjet printing technique are used. For example, the roll-to-roll method is a method of continuous deposition of thin film on a substrate in a film deposition chamber, within which film material substrate is disposed and transported continuously by a plurality of rolls (transport means).

When manufacturing the thin film photovoltaic cell 1, first in step S1 pretreatment of the insulating substrate 2 is performed, as shown in FIG. 5. Specifically, the surface is cleaned and other pretreatment performed by exposing the insulating substrate 2 to a plasma.

Next, in step S2, second penetrating holes 8 are formed in the insulating substrate 2. The second penetrating holes 8 are formed by a punching (perforation) method. The shape of the second penetrating holes 8 is circular, with a diameter of 1 mm. The circular diameters of the second penetrating holes 8 can be set in the range 0.05 to 1 mm, and the number of perforations can be adjusted according to the design.

Next, in step S3, a rear face electrode layer 3a and first back face electrode layer 3b are formed on the two faces of the insulating substrate 2 by sputtering treatment. At this time, the rear face electrode layer 3a and first back face electrode layer 3b are electrically connected via the second penetrating holes 8.

Thereafter, in step S4 the layers formed on both faces of the insulating substrate 2 are removed in a linear shape by laser fabrication to form first patterning lines (not shown). At this time, the lines formed on the two faces of the insulating substrate 2 are mutually shifted.

Then in step S5, first penetrating holes 7 are formed in the insulating substrate 2. The first insulating holes 7 are formed by punching.

Next, in step S6, a photoelectric conversion layer 4 is formed on the rear face electrode layer 3a of the insulating substrate 2, and thereafter, in step S7, a protective layer 11 (insulating layer) is formed, and then in step S8 a transparent electrode layer 5 is formed on the protective layer 11 (insulating layer) and on the photoelectric conversion layer 4 on which no protective layer 11 is disposed.

Next, in step S9, a second back face electrode layer 6 is formed on the first back face electrode layer 3b on the insulating substrate 2.

Next, in step S10, the photoelectric conversion layer 4 and transparent electrode layer 5 on the first patterning lines formed in step S4 are removed again in a linear shape by laser fabrication to form first patterning lines 9.

Further, in step S11 the second back face electrode layer 6 on the first patterning lines formed in step S4 are removed again in a linear shape by laser fabrication to form the second patterning lines 10.
In step S12, the transparent electrode formed in step S8 is isolated by laser fabrication on the peripheries of the second penetrating holes formed in step S2. By this means the transparent electrode layer 5 on the outside of the portion surrounded by the third patterning lines 12 and the metal electrode layer 3 are isolated, the layers on the insulating substrate 2 are separated into a plurality of unit cells by the first and second patterning lines 9 and 10, and series connection of the thin film photovoltaic cell 1 is completed.

In the thin film photovoltaic cell 1 of the embodiment of the invention, the rear face electrode layer 3a, photoelectric conversion layer 4 and transparent electrode layer 5 are stacked in this order on the face on the light-receiving side, which is the side F, of the insulating substrate 2, the first back face electrode layer 3b and second back face electrode layer 6 are stacked in this order on the face on the non-light receiving side, which is the side R, of the insulating substrate 2, and first and second patterning lines 9 and 10 are formed alternately in the layers stacked on the two faces of the insulating substrate 2 to divide the insulating substrate 2 into a plurality of unit cells; in the thin film photovoltaic cell 1, the transparent electrode layer 5 and the second back face electrode layer 6 are electrically connected via first penetrating holes 7 which penetrate the insulating substrate 2, the rear face electrode layer 3a and the first back face electrode layer 3b are electrically connected via second penetrating holes 8 which penetrate the insulating substrate 2, and adjacent unit cells are connected in series, and by isolating or removing the transparent electrode 5 on the peripheries of the second penetrating holes 8, the transparent electrode and the rear electrode 3 and back face electrode 6 in the power generation region are isolated.

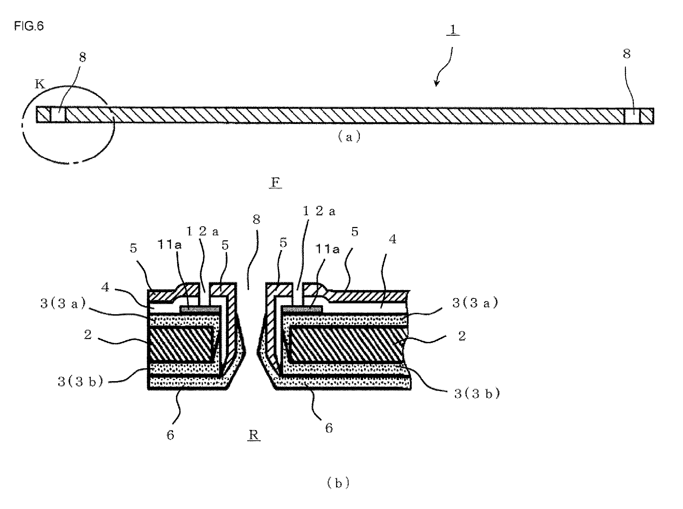

Next, the thin film photovoltaic cell 11 of a second embodiment of the invention, which is a separate example, is explained using FIG. 6.

FIG. 6A shows a cross-sectional view of the thin film photovoltaic cell 11 of a second embodiment, corresponding to the G-G cross-section in FIG. 1 and FIG. 6B is an enlarged cross-sectional view of the portion K in FIG. 6A.
A difference with FIG. 3B of the first embodiment is the fact that the protective layer 11a exists on the rear face electrode layer 23a, and thereafter the photoelectric conversion layer 4 and transparent electrode layer 5 are stacked in this order. Hence the third patterning lines 12a isolate not only the transparent electrode layer 5, but the photoelectric conversion layer 4 as well.

Thus by using a configuration in which the transparent electrode layer 5 is isolated on the peripheries of the second penetrating holes 8, so that the transparent electrode and the rear face electrode 3 and back face electrode 6 can be isolated in the power generation region, the protective layers 11 and 11a may be disposed either between the photoelectric conversion layer 4 and the transparent electrode layer 5, or between the rear face electrode layer 23a and the photoelectric conversion layer 4.

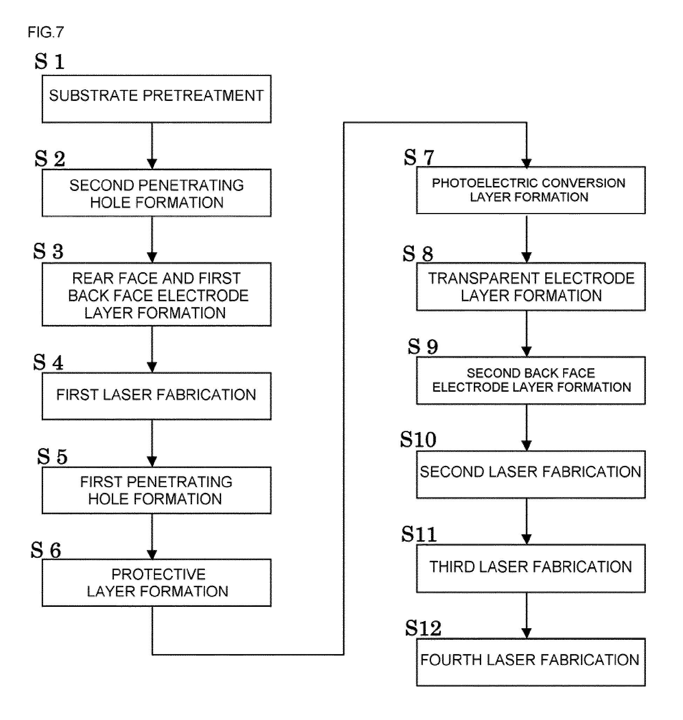

The method of manufacture of a thin film photovoltaic cell of the second embodiment of the invention when manufacturing the thin film photovoltaic cell 11 is shown in the flowchart of FIG. 7. A difference with FIG. 5, which is the flowchart when manufacturing the thin film photovoltaic cell 1 of the first embodiment of the invention, is that the processes of steps S6 and S7 of forming the photoelectric conversion layer 4 and forming the protective layers 11 and 11a are switched. In FIG. 7, the process of forming the protective layer 11a is step S6, but the process of forming the protective layer 11a may be performed after formation of the rear face electrode layer 3a and first back face electrode layer 3b in step S3 and before formation of the photoelectric conversion layer 4 in step S7.

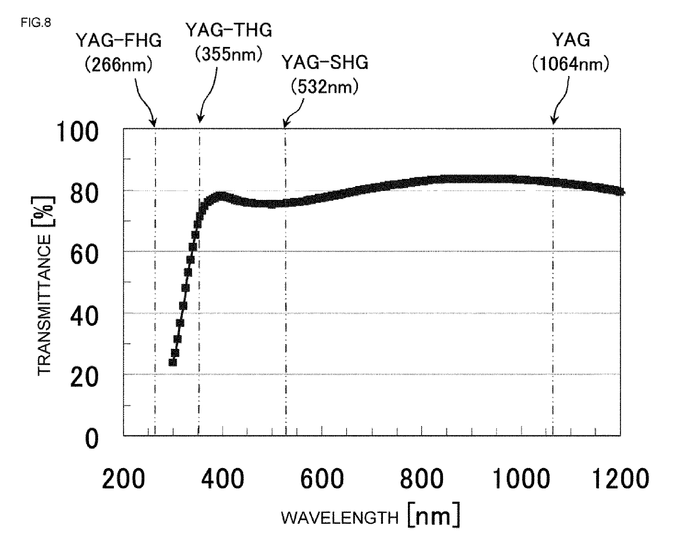

Next, means of forming the third patterning lines 12 and 12a are explained. As means of isolating the transparent electrode layer 5 and the rear face electrode layer 3a and back face electrode layer 3b, a laser is used. As in the example of FIG. 8, the longer the wavelength of the irradiating light, the higher is the transmittance of the transparent electrode film (for example, for a YAG-SHG at wavelength 532 nm, the transmittance is 75%). If transmitted laser light irradiates the photoelectric conversion layer 4 therebelow, the photoelectric conversion layer undergoes thermal damage. Thermal damage means crystallization caused by heat, so that resistivity is lowered and insulating properties are degraded.
In this invention, in order to alleviate thermal damage to the photoelectric conversion layer 4, a layer structure is used in which a protective layer 11 using an insulating material is inserted between the photoelectric conversion layer 4 and the transparent electrode layer 5. As the insulating material, a liquid polyimide with vacuum durability, heat resistance, wear resistance and degassing resistance was used, and was applied by a dispenser method on the photoelectric conversion layer 4 over the range of the protective layer 11 shown in FIG. 4. The method of applying the insulating material is not limited to this method.
In the above-described layer structure, fabrication of the transparent electrode layer 5 was performed using a laser (YAG-SHG) of wavelength 532 nm. As a result, the isolation resistance across the inside and outside of fabricated lines in the transparent electrode layer 5 was several MΩ. It was confirmed that when there was no protective layer 12, the rear face electrode layer 3a and photoelectric conversion layer 4 melt, the isolation resistance is 100 Ω, and adequate insulation and isolation was obtained.

As explained above, in this invention a process of isolating the transparent electrode layer 5 on the peripheries of the penetrating holes 8 is included, so that there is no longer a need to perform mask treatment in the vicinity of the second penetrating holes as in the prior art, and production yields when manufacturing thin film photovoltaic cells 1 are improved.
In addition, there is no longer a need to perform mask treatment in the vicinity of the second penetrating holes 8, so that contact of the mask with layers on the insulating substrate 2 and damage to layers on the insulating substrate 2 are also eliminated. Hence there are no increases in leakage currents in the thin film photovoltaic cell 1, and the defect rate when manufacturing thin film photovoltaic cells 1 can be lowered.

### EXPLANATION OF REFERENCE NUMERALS

- 1, 11, 21: Thin film photovoltaic cell
- 2, 22: Insulating substrate
- 3, 23: Metal electrode layer
- 3a, 23a: Rear face electrode layer
- 3b, 23b: First back face electrode layer
- 4, 24: Photoelectric conversion layer
- 5, 25: Transparent electrode layer
- 6, 26: Second back face electrode layer
- 7, 27: First penetrating hole
- 8, 28: Second penetrating hole
- 9, 29: First patterning line
- 10, 30: Second patterning line
- 11, 11a: Protective layer
- 12, 12a: Third patterning line

## Claims

1. A thin film photovoltaic cell, comprising: a rear face electrode layer, a photoelectric conversion layer and a transparent electrode layer stacked in this order on one face of an insulating substrate, and a back face electrode layer deposited on the other face of the insulating substrate,
the insulating substrate being divided into a plurality of unit cells by alternately forming patterning lines in the layers stacked on the two faces of the insulating substrate, the transparent electrode layer and the back face electrode layer being electrically connected via a first penetrating hole which penetrates the insulating substrate, the rear face electrode layer and the back face electrode layer being electrically connected via a second penetrating hole which penetrates the insulating substrate, and adjacent unit cells being connected in series,
wherein a protective layer is provided at least in a region which surrounds the periphery of the second penetrating hole and which is located between the photoelectric conversion layer and the transparent electrode layer, or between the rear face electrode layer and the photoelectric conversion layer, and by using a laser to remove a transparent electrode on the periphery of the second penetrating hole in the region in which the protective layer is formed, the transparent electrode layer and the back face electrode layer are electrically insulated.

2. The thin film photovoltaic cell according to Claim 1, wherein the insulating substrate is formed from a film material.

3. The thin film photovoltaic cell according to Claim 2, wherein the film material is a heat-resistant film of a polyimide, a polyamideimide, or polyethylene naphthalate.

4. The thin film photovoltaic cell according to any one of Claim 1 to Claim 3, wherein the photoelectric conversion layer is any one of an amorphous semiconductor, an amorphous compound semiconductor, a dye-sensitized photovoltaic cell, and an organic photovoltaic cell.

5. A method of manufacture of a thin film photovoltaic cell, comprising the steps of:
forming a second penetrating hole in an insulating substrate;
forming a rear face electrode layer on one face of the insulating substrate, and forming a first back face electrode layer on the other face of the insulating substrate;
forming a first penetrating hole in the insulating substrate after forming the rear face electrode layer and the first back face electrode layer;
stacking a photoelectric conversion layer on the rear face electrode layer;
stacking a protective layer on the photoelectric conversion layer, at least in a region surrounding the periphery of the second penetrating hole;
stacking a transparent electrode layer on the photoelectric conversion layer having a portion on which the protective layer has been stacked, and stacking a second back face electrode layer on the other face of the insulating substrate;
alternately forming patterning lines in the layers stacked on the two faces of the insulating substrate, and dividing the insulating substrate into a plurality of unit cells; and
dividing the transparent electrode layer on the periphery of the second penetrating hole.

6. A method of manufacture of a thin film photovoltaic cell, comprising the steps of:
forming a second penetrating hole in an insulating substrate;
forming a rear face electrode layer on one face of the insulating substrate, and forming a first back face electrode layer on the other face of the insulating substrate;
forming a first penetrating hole in the insulating substrate after forming the rear face electrode layer and the first back face electrode layer;
stacking a protective layer on the rear face electrode layer, at least in a region surrounding the periphery of the second penetrating hole;
stacking a photoelectric conversion layer on the rear face electrode layer having a portion on which the protective layer has been stacked;
stacking a transparent electrode layer on the photoelectric conversion layer, and stacking a second back face electrode layer on the other face of the insulating substrate;
alternately forming patterning lines in the layers stacked on the two faces of the insulating substrate, and dividing the insulating substrate into a plurality of unit cells; and
dividing the transparent electrode layer on the periphery of the second penetrating hole.

7. The method of manufacture of a thin film photovoltaic cell according to Claim 5 or Claim 6, wherein an insulating material which is a polyimide resin having an optical absorptivity at wavelength 532 nm of 20% or higher is used in the protective layer.

8. The method of manufacture of a thin film photovoltaic cell according to any one of Claim 5 to Claim 7, wherein isolation of the transparent electrode layer is performed using a laser of wavelength 193 nm to 532 nm.
